# EUROPÄISCHE PATENTSCHRIFT

(11) **EP 1 661 190 B1**
(45) Veröffentlichungstag und Bekanntmachung des Hinweises auf die Patenterteilung: **23.11.2016**
(21) Anmeldenummer: 04764739.1
(22) Anmeldetag: 02.09.2004
(51) Int. Cl.: B41J 2/14, F04B 43/04, H01L 41/047, H01L 41/09

(54) **PIEZOAKTOR**
PIEZOACTUATOR
ACTIONNEUR PIEZO-ELECTRIQUE

(30) Priorität: 04.09.2003 DE 20313727 U
(43) Veröffentlichungstag der Anmeldung: 31.05.2006
(73) Patentinhaber: THINXXS MICROTECHNOLOGY AG, 66482 Zweibrücken (DE)
(72) Erfinder: WEBER, Lutz, 66482 Zweibrücken (DE)
(74) Vertreter: Bernhardt, Reinhold
(86) Internationale Anmeldenummer: PCT/EP2004/009780
(87) Internationale Veröffentlichungsnummer: WO 2005/024967

(56) Entgegenhaltungen:
- EP-A- 0 733 480
- EP-A- 0 786 345
- DE-A- 4 443 244
- DE-C1- 19 546 570
- JP-K1- S55 109 668
- US-A1- 2002 140 786
- US-A1- 2002 149 653
- US-B1- 6 297 578
- PATENT ABSTRACTS OF JAPAN Bd. 0071, Nr. 99 (M-240), 3. September 1983 (1983-09-03) -& JP 58 098259 A (MATSUSHITA DENKI SANGYO KK), 11. Juni 1983 (1983-06-11)
- HARTMANN HANS-JOACHIM ET AL.: "Micromoulded Plastic Components" MEDICAL DEVICE TECHNOLOGY. APR 2002, Bd. 13, Nr. 3, April 2002 (2002-04), Seiten 28-30, XP002310052 ISSN: 1048-6690

## Beschreibung

Die Erfindung betrifft Piezoaktoren für miniaturisierte Pumpen, Zerstäuber, Ventile oder dergleichen, gemäß Oberbegriff der unabhängigen Ansprüche 1 und 2, mit einer Piezoscheibe und einer an die Piezoscheibe gekoppelten Gegenhalterscheibe, die in einem Randbereich fluiddicht mit einem Substrat verbunden ist und sich durch die Piezoscheibe unter Änderung des Volumens einer zwischen der Gegenhalterscheibe und dem Substrat gebildeten Kavität wölben lässt, und die eine zwischen dem verbundenen Randbereich und der Piezoscheibe verlaufende, beim Wölben der Gegenhalterscheibe ein Gelenk bildende Schwachstelle in Form einer Ringnut bzw. einer Stufenausnehmung aufweist, wobei der Absatz der Stufenausnehmung, in Draufsicht auf die Piezoscheibe gesehen, seitlich im Abstand sowohl zu dem verbundenen Randbereich als auch zu der Piezoscheibe verläuft.

Ein Piezoaktor gemäß Oberbegriff des Anspruchs 1 geht aus JP 58098259 hervor. Eine rechteckige Platte und ein rechteckiges, mit der Platte verbundenes Substrat dienen als gemeinsame Gegenhalterscheibe und gemeinsames Substrat für mehrere solcher Piezoaktoren. In einer zur Plattenebene parallelen Projektionsebene verläuft jeweils eine im Querschnitt U-förmige Ringnut sowohl angrenzend an den mit dem Substrat verbundenen Teil der Platte als auch angrenzend an die Piezoscheibe. Durch die Gelenke bildende Ringnut wird die Wölbung der Gegenhalterscheibe erleichtert und die an die Piezoscheibe zu legende Signalspannung lässt sich reduzieren.

Ein Piezoaktor gemäß Oberbegriff des Anspruchs 2 geht aus der DE 19546570 C1 hervor. Die die Schwachstelle bildende Stufenausnehmung ist durch eine zentrale Vertiefung in der Gegenhalterscheibe gebildet, wobei die Piezoscheibe in die Vertiefung eingesetzt ist. Der Rand der zentralen Vertiefung bildet den Stufenabsatz, welcher sowohl im Abstand zu der Piezoscheibe als auch zu dem verbundenen Randbereich, in welchem die Gegenhalterscheibe mit dem Substrat verbunden ist, verläuft.

Je nach den Abmessungen des Substrats, z.B. eines rotationssymmetrischen Pumpenkörpers mit einem Durchmesser zwischen 5 und 25 mm und einer Dicke zwischen 0,3 und 2 mm, kann es bei der Wölbung der Gegenhalterscheibe zu einer Mitverformung des Substrats kommen, welche einer gewünschten Änderung des Volumens der Kavität entgegenwirkt. Der Aktor erreicht dann nicht seinen vollen Wirkungsgrad. Auf das Ausmaß der Wirkungsgradminderungen haben Schwankungen von Fertigungsmaßen und Materialeigenschaften erheblichen Einfluss, so dass im Hinblick auf möglichst konstante Leistungsdaten enge Toleranzabweichungen eingehalten werden müssen. Entsprechend instabil ist der Fertigungsprozess.

Der vorliegenden Erfindung liegt die Aufgabe zugrunde, einen neuen Piezoaktor der eingangs erwähnten Art zu schaffen, der sich gegenüber dem Stand der Technik bei erhöhter Fertigungssicherheit mit geringerem Aufwand herstellen lässt.

Ein diese Aufgabe lösender Piezoaktor gemäß Oberbegriff des Anspruchs 1 ist dadurch gekennzeichnet, dass die Ringnut, in Draufsicht auf die Piezoscheibe gesehen, seitlich im Abstand sowohl zu dem verbundenen Randbereich als auch zu der Piezoscheibe verläuft.

Eine zweite Lösung gemäß Oberbegriff des Anspruchs 2 ist dadurch gekennzeichnet, dass die Stufenausnehmung eine ringförmige Stufenausnehmung am Rand der Gegenhalterscheibe ist.

Unabhängig von Maßschwankungen und geänderten Materialeigenschaften erreicht der Aktor seinen vollen Wirkungsgrad.

Vorteilhaft lässt sich eine solche Gegenhalterscheibe einstückig als Kunststoffspritzteil herstellen.

In einer Ausführungsform ist die Schwachstelle sowohl durch eine Ringnut als auch durch eine Stufenausnehmung gebildet.

Die Ringnut oder Stufenausnehmung kann auf einer dem Substrat abgewandten oder zugewandten Seite der Gegenhalterscheibe gebildet sein. Denkbar sind auch Ringnuten oder Stufenausnehmungen auf beiden Seiten der Gegenhalterscheibe, wobei die betreffenden Ringnuten bzw. Stufenausnehmungen einander gegenüberliegen.

Vorzugsweise weist die Ringnut eine einzige tiefstgelegene Fußlinie auf und ist vorzugsweise im Querschnitt U- oder V-förmig ausgebildet. Durch eine solche Querschnittsform ist die Lage des durch die Schwachstelle gebildeten Gelenks genau, nämlich durch die Fußlinie, festgelegt. Schwankungen von Fertigungsmaß- und Materialeigenschaften haben auf das Wölbungsverhalten dann nur noch geringen Einfluss.

In der bevorzugten Ausführungsform der Erfindung ist die Gegenhalterscheibe mit dem Substrat verklebt oder verschweißt.

Vorzugsweise beträgt die verbleibende Materialdicke an der Schwachstelle etwa 10 bis 30% der Dicke der Gegenhalterscheibe.

In weiterer vorteilhafter Ausgestaltung der Erfindung weist die Gegenhalterscheibe eine, ggf. zu der Ringnut oder/und Stufenausnehmung hin offene, Ausnehmung für die Zuführung eines Anschlussleiters an eine der Gegenhalterscheibe zugewandte Elektrode der Piezoscheibe auf.

In weiterer Ausgestaltung der Erfindung kann eine Elektrode auf einer der Gegenhalterscheibe abgewandten Seite der Piezoscheibe eine Randaussparung aufweisen, in welche eine elektrisch mit einer der Elektrode gegenüberliegenden Elektrode verbundene Kontaktschicht hineinreicht. Vorteilhaft sind in diesem Fall Kontaktierungen der Elektroden der Piezoscheibe ausschließlich von der der Gegenhalterscheibe abgewandten Seite her möglich.

Die Erfindung soll nachfolgend anhand von Ausführungsbeispielen und der beiliegenden, sich auf diese Ausführungsbeispiele beziehenden Zeichnungen näher erläutert werden. Es zeigen:
- Fig. 1: wesentliche Teile einer Mikropumpe mit einem Aktor gemäß einem ersten Ausführungsbeispiel für die vorliegende Erfindung,
- Fig. 2 bis 4: Teildarstellungen einer Mikropumpe mit Aktoren gemäß weiteren Ausführungsbeispielen für die vorliegende Erfindung,
- Fig. 5: ein erstes Ausführungsbeispiel für die Kontaktierung der Piezoscheibe eines Aktors nach der Erfindung, und
- Fig. 6: ein zweites Ausführungsbeispiel für die Kontaktierung der Piezoscheibe in einem Aktor nach der Erfindung.

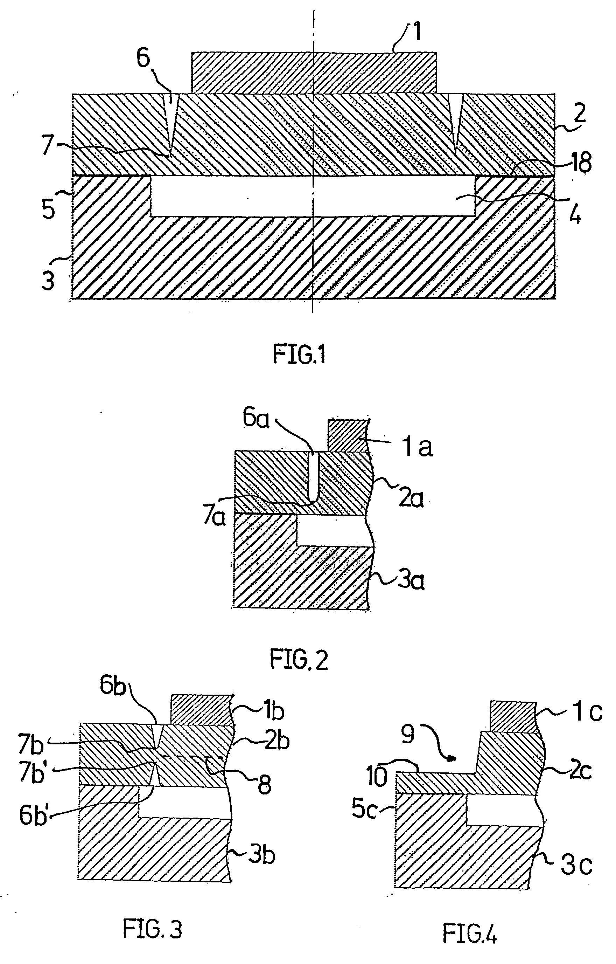

Eine in Fig. 1 gezeigte Mikropumpe weist eine keramische Piezoscheibe 1, eine an die Piezoscheibe gekoppelte, über den Rand der Piezoscheibe hinaus vorstehende Gegenhalterscheibe 2 und einen mit der Gegenhalterscheibe verbundenen Pumpenkörper 3 auf. Der Pumpenkörper stimmt im Durchmesser mit der Gegenhalterscheibe überein. Zwischen der Gegenhalterscheibe und dem Pumpenkörper ist eine Pumpkavität 4 gebildet. Die genannten Teile sind rotationssymmetrisch, können aber von einer solchen Form auch abweichen.

Einzelheiten der Mikropumpe, wie Ventile, Kanäle und Elektroden der Piezoscheibe, sind in Fig. 1 nicht gezeigt.

Die Piezoscheibe besteht in dem gezeigten Ausführungsbeispiel aus einem Keramikmaterial. Bei der Gegenhalterscheibe und dem Pumpenkörper handelt es sich um einstückige Spritzgussteile aus Kunststoff, deren Durchmesser in dem gezeigten Ausführungsbeispiel etwa 10 mm beträgt. Die Dicke der Gegenhalterscheibe liegt bei 0,7 mm.

Die Piezoscheibe ist über ihre gesamte, der Gegenhalterscheibe zugewandte Seite mit der Gegenhalterscheibe 2 verklebt, wozu z.B. ein elektrisch leitender, eine Elektrode der Piezoscheibe bildender Kleber verwendet und die Kleberschicht zur Bildung einer Kontaktierungsfahne aus dem Klebespalt herausgeführt werden könnte. Eine Klebverbindung besteht ferner zwischen einem ringförmigen Randbereich 18 der Gegenhalterscheibe und einem Ringvorsprung 5 des Pumpenkörpers, dessen Höhe der Tiefe der Pumpkavität entspricht.

In der Draufsicht auf die Mikropumpe gesehen ist zwischen der Piezoscheibe 1 und dem Innenrand des Ringvorsprungs 5 bzw. Randbereichs 18 in der Gegenhalterscheibe eine Ringnut 6 gebildet, deren Querschnitt eine V-Form aufweist und deren tiefstgelegene Fußlinie 7 etwa in der Mitte zwischen dem Rand der Piezoscheibe und dem genannten Innenrand verläuft.

Liegt an der Piezoscheibe 1 keine Spannung, so hat sie die in Fig. 1 gezeigte ebene Form. Bei Anlegen einer positiven Spannung zieht sie sich zusammen, wodurch sie sich gemeinsam mit der Gegenhalterscheibe 2 in der Art eines Bimetallelements krümmt. Dabei wölbt sich die rundum mit dem Pumpenkörper 3 verbundene Gegenhalterscheibe in die Pumpkavität 4 hinein und verringert deren Volumen. Durch periodisches Anlegen einer Spannung an die Piezoscheibe lässt sich eine Pumpwirkung erzielen.

Durch die Ringnut 6 ist die Gegenhalterscheibe entlang dem verklebten Randbereich 18 derart geschwächt, dass ein Gelenk gebildet ist, welches eine Übertragung der Wölbung der Gegenhalterscheibe auf deren Randbereich und über die Klebverbindung auf den Pumpenkörper verhindert. Die Lage dieses Gelenks ist durch die Fußlinie 7 exakt festgelegt. Eine Mitwölbung des Pumpenkörpers 3 würde zur Folge haben, dass die mit der Wölbung der Gegenhalterscheibe 2 verbundene Volumenänderung der Pumpkavität 4 teilweise aufgehoben und die gewünschte Pumpwirkung nicht erreicht würde.

In den nachfolgenden Figuren sind einige gleiche oder gleichwirkende Teile mit derselben Bezugszahl wie in Fig. 1 bezeichnet, wobei der betreffenden Bezugszahl der Buchstabe a, b usw. beigefügt ist.

Bei dem Ausführungsbeispiel von Fig. 2 ist in einer Gegenhalterscheibe 2a eine Ringnut 6a gebildet, deren Querschnitt nicht V- sondern U-förmig ist, Auch in diesem Fall weist die Ringnut eine einzige tiefstgelegene Fußlinie 7a auf, welche exakt die Lage des durch die Ringnut 6a gebildeten Gelenks bestimmt.

Bei dem Ausführungsbeispiel von Fig. 3 sind in einer Gegenhalterscheibe 2b zwei Ringnuten 6b und 6b' mit einem V-Profil gebildet, deren Fußlinien 7b und 7b', in der Draufsicht auf die Pumpe gesehen, zueinander ausgerichtet sind. Beide Ringnuten sind gleich tief. Zwischen den Fußlinien verbleibt etwa 25% der Materialdicke der Gegenhalterscheibe. Vorteilhaft durchstößt den verbleibenden Materialbereich eine neutrale Biegelinie 8 der Gegenhalterscheibe. Zug- und Druckbelastungen dieses Bereichs sind minimiert.

Bei dem Ausführungsbeispiel von Fig. 4 weist eine Gegenhalterscheibe 2c anstelle einer Ringnut 6 eine Stufenausnehmung 9 auf, wobei die Breite einer durch die Stufenausnehmung 9 gebildeten Ringschulter 10 etwas größer als die Breite eines mit der Gegenhalterscheibe 2c verbundenen Ringvorsprungs 5c ist.

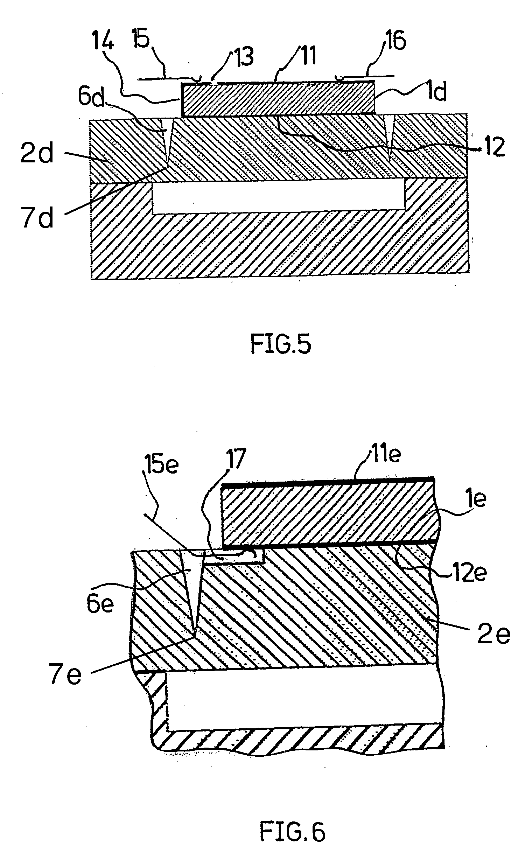

Die in Fig. 5 gezeigte Mikropumpe, welche weitgehend der Mikropumpe von Fig. 1 entspricht, weist eine Piezoscheibe 1 d mit Elektroden 11 und 12 auf, welche durch Metallschichten auf der Piezokeramik gebildet sind. Während die Elektrode 12 die gesamte, der Gegenhalterscheibe 2d Gegeiilialtewaheilse zugewandte Fläche der Piezoscheibe einnimmt, ist in der Elektrode 11 auf der Oberseite der Piezoscheibe eine Randaussparung 13 gebildet, in die eine mit der Elektrode 12 verbundene, die Piezoscheibe am Rand umgreifende Kontaktschicht 14 hineinragt. Somit besteht die Möglichkeit, Anschlussleiter 15 und 16 für die Elektroden 11 und 12 ausschließlich auf der der Gegenhalterscheibe abgewandten Seite der Piezoscheibe, unbeeinträchtigt durch eine Ringnut 6d, anzubringen.

Bei dem Ausführungsbeispiel von Fig. 6 sind an einer Piezoscheibe 1 e Elektroden 11 e und 12e angebracht, die sich jeweils über die gesamte Scheibenfläche erstrecken. Eine mit einer Ringnut 6e in Verbindung stehende Ausnehmung 17 ermöglicht den Anschluss eines Anschlussleiters 15e an der Elektrode 12e.

## Patentansprüche

1. Piezoaktor für miniaturisierte Pumpen, Zerstäuber, Ventile oder dergleichen, mit einer Piezoscheibe (1;1a;1b;1d;1e) und einer an die Piezoscheibe (1;1a;1b;1d;1e) gekoppelten Gegenhalterscheibe (2;2a;2b;2d;2e), die in einem Randbereich (18) fluiddicht mit einem Substrat verbunden ist und sich durch die Piezoscheibe (1;1a;1b;1d;1e) unter Änderung des Volumens einer zwischen der Gegenhalterscheibe (2;2a;2b;2d;2e) und dem Substrat gebildeten Kavität wölben lässt, und die eine zwischen dem verbundenen Randbereich (18) und der Piezoscheibe (1;1a;1b;1d;1e) verlaufende, beim Wölben der Gegenhalterscheibe (2;2a;2b;2d;2e) ein Gelenk bildende Schwachstelle in Form einer Ringnut (6;6a;6b,6b';6d;6e) aufweist, **dadurch gekennzeichnet,**
**dass** die Ringnut (6;6a;6b,6b';6d;6e), in Draufsicht auf die Piezoscheibe (1;1a;1b;1d;1e) gesehen, seitlich im Abstand sowohl zu dem verbundenen Randbereich (18) als auch zu der Piezoscheibe (1;1a;1b;1d;1e) verläuft.

2. Piezoaktor für miniaturisierte Pumpen, Zerstäuber, Ventile oder dergleichen, mit einer Piezoscheibe (1c) und einer an die Piezoscheibe (1c) gekoppelten Gegenhalterscheibe (2c), die in einem Randbereich (18) fluiddicht mit einem Substrat verbunden ist und sich durch die Piezoscheibe (1c) unter Änderung des Volumens einer zwischen der Gegenhalterscheibe (2c) und dem Substrat gebildeten Kavität wölben lässt, und die eine zwischen dem verbundenen Randbereich (18) und der Piezoscheibe (1c) verlaufende, beim Wölben der Gegenhalterscheibe (2c) ein Gelenk bildende Schwachstelle in Form einer Stufenausnehmung (9) aufweist, wobei der Absatz der Stufenausnehmung (9), in Draufsicht auf die Piezoscheibe (1c) gesehen, seitlich im Abstand sowohl zu dem verbundenen Randbereich (18) als auch zu der Piezoscheibe (1c) verläuft,
**dadurch gekennzeichnet,**
**dass** die Stufenausnehmung (9) eine ringförmige Stufenausnehmung am Rand der Gegenhalterscheibe (2c) ist.

3. Piezoaktor nach Anspruch 1 oder 2,
**dadurch gekennzeichnet,**
**dass** die Schwachstelle sowohl durch eine Ringnut (6;6a;6b,6b';6d;6e) als auch einedurch eine Stufenausnehmung (9) gebildet ist.

4. Piezoaktor nach einem der Ansprüche 1 bis 3,
**dadurch gekennzeichnet,**
**dass** die Ringnut (6;6a;6d;6e) oder/und Stufenausnehmung (9) auf einer dem Substrat zugewandten oder abgewandten Seite der Gegenhalterscheibe (2;2a;2c;2d;2e) gebildet ist/sind oder dass auf beiden Seiten der Gegenhalterscheibe (2b) einander gegenüberliegende Ringnuten (6b,6b') oder/und Stufenausnehmungen (9) vorgesehen sind.

5. Piezoaktor nach einem der Ansprüche 1 oder 4,
**dadurch gekennzeichnet,**
**dass** die Ringnut (6;6a;6b,6b';6d;6e) eine einzige tiefstgelegene Fußlinie (7;7a;7b,7b';7d;7e) aufweist und vorzugsweise im Querschnitt V- oder U-förmig ausgebildet ist.

6. Piezoaktor nach einem der Ansprüche 1 bis 5,
**dadurch gekennzeichnet,**
**dass** die an der Schwachstelle verbleibende Materialdicke 10 bis 30% der Dicke der Gegenhalterscheibe (2;2a;2b;2c;2d;2e) beträgt.

7. Piezoaktor nach einem der Ansprüche 1 bis 6,
**dadurch gekennzeichnet,**
**dass** die Gegenhalterscheibe (2e) eine, ggf. zu der Ringnut (6e) oder/und Stufenausnehmung (9) hin offene, Ausnehmung (17) für die Zuführung eines Anschlussleiters (15e) zu einer der Gegenhalterscheibe (2e) zugewandten Elektrode (12e) der Piezoscheibe (1e) aufweist.

8. Piezoaktor nach einem der Ansprüche 1 bis 6,
**dadurch gekennzeichnet,**
**dass** eine Elektrode (11) auf einer der Gegenhalterscheibe (2d) abgewandten Seite der Piezoscheibe ( 1 d) eine Randaussparung (13) aufweist, in welche eine mit einer der Gegenhalterscheibe (2d) zugewandten Elektrode (12) verbundene Kontaktschicht (14) hineingeführt ist.

9. Piezoaktor nach einem der Ansprüche 1 bis 8,
**dadurch gekennzeichnet,**
**dass** die Piezoscheibe (1d;1e) mit der Gegenhalterscheibe (2d;2e) über einen leitfähigen, eine Elektrode (12;12e) bildenden Kleber verbunden und ggf. eine Kleberschicht zur Bildung einer Kontaktierungsfahne aus einem Klebespalt herausgeführt ist.

10. Piezoaktor nach einem der Ansprüche 1 bis 9,
**dadurch gekennzeichnet,**
**dass** die Gegenhalterscheibe (2;2a;2b;2c;2d;2e) ein einstückig im Spritzgießverfahren hergestelltes Kunststoffteil ist.

## Claims

1. Piezoactuator for miniaturized pumps, atomizers, valves or the like, with a piezo disc (1; 1a; 1b; 1d; 1e) and a backing disc (2; 2a; 2b; 2d; 2e), which is coupled to the piezo disc (1; 1a; 1b; 1d; 1e), in an edge region (18) is connected in a fluid-tight manner to a substrate and can be deflected by the piezo disc (1; 1a; 1b; 1d; 1e) by changing the volume of a cavity formed between the backing disc (2; 2a; 2b; 2d; 2e) and the substrate and which has a weak point in the form of an annular groove (6; 6a; 6b, 6b'; 6d; 6e), which extends between the connected edge region (18) and the piezo disc (1; 1a; 1b; 1d; 1e) and which forms a joint during the deflection of the backing disc (2; 2a; 2b; 2d; 2e), **characterized in that**, seen in plan view of the piezo disc (1; 1a; 1b; 1d; 1e), the annular groove (6; 6a; 6b, 6b'; 6d; 6e) extends laterally at a distance both from the connected edge region (18) and from the piezo disc (1; 1a; 1b; 1d; 1e).

2. Piezoactuator for miniaturized pumps, atomizers, valves or the like, with a piezo disc (1c) and a backing disc (2c), which is coupled to the piezo disc (1c), in an edge region (18) is connected in a fluid-tight manner to a substrate, can be deflected by the piezo disc (1c) by changing the volume of a cavity formed between the backing disc (2c) and the substrate and which has a weak point in the form of a stepped recess (9), which extends between the connected edge region (18) and the piezo disc (1c) and which forms a joint during the deflection of the backing disc (2C), the offset of the stepped recess (9), seen in plan view of the piezo disc (1c), extending laterally at a distance both from the connected edge region (18) and from the piezo disc (1c), **characterized in that** the stepped recess (9) is an annular stepped recess at the edge of the backing disc (2c).

3. Piezoactuator according to Claim 1 or 2, **characterized in that** the weak point is formed both by an annular groove (6; 6a; 6b, 6b'; 6d; 6e) and by a stepped recess (9).

4. Piezoactuator according to one of Claims 1 to 3, **characterized in that** the annular groove (6; 6a; 6d; 6e) and/or the stepped recess (9) is/are formed on a side of the backing disc (2; 2a; 2c; 2d; 2e) that is facing towards or away from the substrate or **in that** annular grooves (6b, 6b') and/or stepped recesses (9) are provided on both sides of the backing disc (2b), opposite from one another.

5. Piezoactuator according to either of Claims 1 and 4, **characterized in that** the annular groove (6; 6a; 6b, 6b'; 6d; 6e) has a single lowermost base line (7; 7a; 7b, 7b'; 7d; 7e) and is preferably formed as V-shaped or U-shaped in cross section.

6. Piezoactuator according to one of Claims 1 to 5, **characterized in that** the material thickness remaining at the weak point is 10 to 30% of the thickness of the backing disc (2; 2a; 2b; 2c; 2d; 2e).

7. Piezoactuator according to one of Claims 1 to 6, **characterized in that** the backing disc (2e) has a recess (17), which is possibly open towards the annular groove (6e) and/or the stepped recess (9), for feeding a supply lead (15e) to an electrode (12e) of the piezo disc (1e) that is facing towards the backing disc (2e).

8. Piezoactuator according to one of Claims 1 to 6, **characterized in that** an electrode (11) on a side of the piezo disc (1d) that is facing away from the backing disc (2d) has an edge clearance (13), into which a contact layer (14) connected to an electrode (12) facing towards the backing disc (2d) is led.

9. Piezoactuator according to one of Claims 1 to 8, **characterized in that** the piezo disc (1d; 1e) is connected to the backing disc (2d; 2e) by way of a conductive adhesive, forming an electrode (12; 12e), and an adhesive layer for forming a contacting lug is possibly led out from an adhesive gap.

10. Piezoactuator according to one of Claims 1 to 9, **characterized in that** the backing disc (2; 2a; 2b; 2c; 2d; 2e) is a plastic part that is produced in one piece by the injection-moulding process.

## Revendications

1. Actionneur piézoélectrique pour pompes, pulvérisateurs, soupapes ou analogues, miniaturisés, présentant un disque piézoélectrique (1;1a;1b;1d;1e) et un contre-disque (2;2a;2b;2d;2e), accouplé au disque piézoélectrique (1;1a;1b;1d;1e), qui est relié, dans une zone de bord (18), de manière fluidiquement étanche à un substrat et qui peut être cintré par le disque piézoélectrique (1;1 a;1 b;1 d;1 e) avec modification du volume d'une cavité formée entre le contre-disque (2;2a;2b;2d;2e) et le substrat et qui présente un point de fragilisation, sous forme d'une rainure annulaire (6;6a;6b,6b';6d;6e), s'étendant entre la zone de bord (18) de liaison et le disque piézoélectrique (1;1a;1b;1d;1e), formant une articulation lors du cintrage du contre-disque (2;2a;2b;2d;2e), **caractérisé en ce que** la rainure annulaire (6;6a;6b,6b';6d;6e), observée en vue du dessus sur le disque piézoélectrique (1;1a;1b;1d;1e), s'étend latéralement à une certaine distance, tant de la zone de bord (18) de liaison que du disque piézoélectrique (1;1a;1b;1d;1e).

2. Actionneur piézoélectrique pour pompes, pulvérisateurs, soupapes ou analogues, miniaturisés, présentant un disque piézoélectrique (1c) et un contre-disque (2c), accouplé au disque piézoélectrique (1c), qui est relié, dans une zone de bord (18), de manière fluidiquement étanche à un substrat et qui peut être cintré par le disque piézoélectrique (1c) avec modification du volume d'une cavité formée entre le contre-disque (2c) et le substrat et qui présente un point de fragilisation, sous forme d'une entaille à échelon (9), s'étendant entre la zone de bord (18) de liaison et le disque piézoélectrique (1c), formant une articulation lors du cintrage du contre-disque (2c), le talon de l'entaille à échelon (9), observé en vue du dessus sur le disque piézoélectrique (1c), s'étendant latéralement à une certaine distance, tant de la zone de bord (18) de liaison que du disque piézoélectrique (1c), **caractérisé en ce que** l'entaille à échelon (9) est une entaille à échelon annulaire au niveau du bord du contre-disque (2c).

3. Actionneur piézoélectrique selon la revendication 1 ou 2, **caractérisé en ce que** le point de fragilisation est formé tant par une rainure annulaire (6;6a;6b,6b';6d;6e) que par une entaille à échelon (9).

4. Actionneur piézoélectrique selon l'une quelconque des revendications 1 à 3, **caractérisé en ce que** la rainure annulaire (6;6a;6d;6e) et/ou l'entaille à échelon (9) est/sont formée(s) sur un côté du contre-disque (2;2a;2c;2d;2e) orienté vers le substrat ou opposé à celui-ci ou **en ce que** des rainures annulaires (6b,6b') et/ou des entailles à échelon (9) opposées l'une à l'autre sont disposées sur les deux côtés du contre-disque (2b).

5. Actionneur piézoélectrique selon l'une quelconque des revendications 1 ou 4, **caractérisé en ce que** la rainure annulaire (6;6a;6b,6b';6d;6e) présente une seule ligne de fond (7;7a;7b,7b';7d;7e) au plus profond et est de préférence réalisée avec une section en forme de V ou de U.

6. Actionneur piézoélectrique selon l'une quelconque des revendications 1 à 5, **caractérisé en ce que** l'épaisseur de matériau qui reste au niveau du point de fragilisation représente 10 à 30% de l'épaisseur du contre-disque (2;2a;2b;2c;2d;2e).

7. Actionneur piézoélectrique selon l'une quelconque des revendications 1 à 6, **caractérisé en ce que** le contre-disque (2e) présente une entaille (17), le cas échéant ouverte vers la rainure annulaire (6e) et/ou vers l'entaille à échelon (9), pour amener un conducteur de raccordement (15e) vers une électrode (12e), orientée vers le contre-disque (2e), du disque piézoélectrique (1e).

8. Actionneur piézoélectrique selon l'une quelconque des revendications 1 à 6, **caractérisé en ce qu'**une électrode (11) présente, sur un côté, opposé au contre-disque (2d), du disque piézoélectrique (1d), une échancrure de bord (13), dans laquelle est introduite une couche de contact (14) reliée à une électrode (12) orientée vers le contre-disque (2d).

9. Actionneur piézoélectrique selon l'une quelconque des revendications 1 à 8, **caractérisé en ce que** le disque piézoélectrique (1d;1e) est assemblé au contre-disque (2d;2e) via une colle conductrice, formant une électrode (12;12e) et une couche de colle sort le cas échéant d'une fente de collage pour la formation d'une lame de mise en contact.

10. Actionneur piézoélectrique selon l'une quelconque des revendications 1 à 9, **caractérisé en ce que** le contre-disque (2;2a;2b;2c;2d;2e) est une pièce en matériau synthétique réalisée en une seule pièce dans un procédé de moulage par injection.
